# EUROPEAN PATENT APPLICATION

(11) **EP 4 804 416 A1**
(43) Date of publication of application: **09.09.2026**
(21) Application number: 26162029.8
(22) Date of filing: 03.03.2026
(51) Int. Cl.: H04B 3/00, H04N 23/50, H04N 23/54, H04N 23/55, H04N 23/57, G06F 15/76

(54) **APPARATUS WITH AN OPTICAL DEVICE HAVING AN OBJECTIVE LENS SYSTEM AND WITH AN ELECTRONIC CONTROL SYSTEM HAVING A PLURALITY OF CIRCUIT BOARDS**

(30) Priority: 07.03.2025 AT 501462025; 10.03.2025 AT 501512025
(71) Applicant: Swarovski-Optik AG & Co KG., 6067 Absam (AT)
(72) Inventor: KLINGENSCHMID, Lukas, 6112 Wattens (AT); MUIGG, Julian, 6020 Innsbruck (AT); ZANGERL, Rene, 6060 Hall in Tirol (AT); REITER, Bernhard, 6020 Innsbruck (AT); PLATZGUMMER, Valentin, 6020 Innsbruck (AT)
(74) Representative: Burger, Hannes Alfred

(57) **Abstract**

An apparatus comprising an optical device (1) having an objective lens system (3) with a primary optical path (8) and an electronic control system, wherein the electronic control system comprises: a main circuit board (16) with a main processor (17) and at least an electronic interface for communication with a data bus, and at least two subordinate circuit boards (21, 24), characterized in that each of the two subordinate circuit boards (21, 24) comprises a controller and at least an electronic interface for communication with the data bus, wherein the main circuit board (16) and each of the two subordinate circuit boards (21, 24) are connected to the data bus, and wherein the subordinate circuit boards (21, 24) are in communication with the main circuit board (16) over the data bus, and wherein at least one of the subordinate circuit boards (21, 24) comprises a measuring device (23, 26).

## Description

The invention concerns an apparatus comprising an optical device having an objective lens system with a primary optical path and an electronic control system.

The object of the invention is to provide an optical apparatus equipped with electronically controlled features that allows for a more flexible and cost-effective construction.

The said object is achieved by an apparatus comprising an optical device having an objective lens system with a primary optical path and an electronic control system, wherein the electronic control system comprises: a main circuit board with a main controller and at least an electronic interface for communication with a data bus, and at least two subordinate circuit boards, wherein each of the two subordinate circuit boards comprises a controller and at least an electronic interface for communication with the data bus, wherein the main circuit board and each of the two subordinate circuit boards are connected to the data bus, and wherein the subordinate circuit boards are in communication with the main circuit board over the data bus, and wherein at least one of the subordinate circuit boards comprises a measuring device.

According to a preferred embodiment of the apparatus the controller of each of the subordinate circuit boards is designed such that a measurement is executed independently from the main controller.

Moreover, it is advantageous if the main circuit board and the subordinate circuit boards are arranged outside the primary optical path with the main circuit board lying in a first plane and the subordinate circuit boards lying in a second plane that is inclined relative to the first plane.

In an advantageous advancement, it is provided that the first plane and/or the second plane is aligned parallel to an adjacent portion of the primary optical path.

According to an alternative embodiment of the apparatus only one of the first plane and the second plane is aligned perpendicular to an adjacent portion of the primary optical path.

Moreover, the embodiment of the apparatus wherein the measuring device is selected from a group consisting of an IMU module (Inertial Measurement Unit), a compass, a thermometer, a barometer, a rangefinder, a microphone, a module for wind speed measurement and a module for cross wind measurement, is also advantageous.

In an advantageous advancement of the apparatus the subordinate circuit board comprises a device for communication, wherein the device for communication is selected from a group consisting of a Bluetooth module, a WIFI module, a loudspeaker and a graphics module for outputting image information data to a display arranged in the primary optical path.

It proves particularly advantageous if the subordinate circuit board includes a second controller or a GPU.

An embodiment of the apparatus, in which the second controller comprises a CPU or a GPU is advantageous.

In an advantageous advancement, the subordinate circuit board comprises a memory.

According to an advantageous design of the apparatus the subordinate circuit board comprises a volatile memory.

In a preferred embodiment the subordinate circuit board comprises a non-volatile memory.

In particular, the approach is advantageous according to which the data bus comprises a flexible data connection and at least one of the flexible data connections is equipped with a connector having a unique physical configuration to receive a specific connector of only one sensor of the group of sensors or of only one of the devices of the group of devices for communication.

In an advantageous advancement, it is provided that a connection of a first flexible data connection to the main circuit board is via a first connector on the main circuit board that comprises a plug-and-play bus.

An advancement in which the subordinate circuit board includes a second connector and the flexible data connection comprises a cable assembly connecting the main circuit board to the subordinate circuit board, wherein the cable assembly has a first end portion connected to the first connector and has a second end portion connected to the second connector, is also advantageous.

Moreover, the embodiment of the apparatus wherein a first tangent applied to the first end portion of the cable assembly and a second tangent applied to the second end portion of the cable assembly enclose an angle which angle is equal to an angle of inclination between the first plane of the main circuit board and the second plane of the subordinate circuit board, is also advantageous.

According to a preferred embodiment of the apparatus, in an assembled state, the main circuit board, the subordinate circuit boards, and the cable assembly connecting the main circuit board and the subordinate circuit boards can be laid out together in essentially a single common plane prior to installation in the optical device.

In an advantageous advancement, it is provided that an another subordinate circuit board is comprised, wherein a third plane of the another subordinate circuit board is aligned relative to the second plane of the subordinate circuit board so that the third plane is inclined relative to the second plane.

A preferred embodiment of the apparatus is characterized in that a battery is comprised.

The object of the invention is also independently achieved by an apparatus for the electronic or electromechanical control of an optical device, the apparatus comprising: a main circuit board with a main controller and at least an electronic interface for communication with a data bus, and at least two subordinate circuit boards, characterized in that each of the two subordinate circuit boards comprises a controller and at least an electronic interface for communication with the data bus, wherein the main circuit board and each of the two subordinate circuit boards are connected to the data bus, and wherein the subordinate circuit boards are in communication with the main circuit board over the data bus, and wherein at least one of the subordinate circuit boards comprises a measuring device.

In an advantageous advancement a first connector of the main circuit board and a second connector of the subordinate circuit boards are connected to one another, wherein the first flexible data connection comprises a cable assembly which has a first end portion and a second end portion.

For the purpose of better understanding of the invention, it will be elucidated in more detail by means of the figures below.

These show in a respectively very simplified schematic representation:
- Fig. 1: an optical imaging device formed by a sighting telescope;
- Fig. 2: a cross-section through the sighting telescope according to Fig. 1;
- Fig. 3: an optical imaging device with its electronic control system as a block diagram;
- Fig. 4: a detail of the block diagram according to Fig. 3;
- Fig. 5: an exemplary embodiment of the optical imaging device formed by a binocular shown in a top view;
- Fig. 6: a cross-section of the binocular according to Fig. 5;
- Fig. 7: an exemplary embodiment of the optical imaging device formed by a monocular observation device;
- Fig. 8: a schematic diagram of a preferred exemplary embodiment of the device in the form of a sighting telescope;
- Fig. 9: an electronic control system of the sighting telescope according to Fig. 8;
- Fig. 10: the range-finding electronics of the electronic control system according to Fig. 9;
- Fig. 11: the module of the radiation transmitter according to Fig. 9;
- Fig. 12: the module of the radiation detector according to Fig. 9;
- Fig. 13: the module of the inertial measurement unit according to Fig. 9;
- Fig. 14: the module of the display according to Fig. 9.

First of all, it is to be noted that in the different embodiments described, equal parts are provided with equal reference numbers and/or equal component designations, where the disclosures contained in the entire description may be analogously transferred to equal parts with equal reference numbers and/or equal component designations. Moreover, the specifications of location, such as at the top, at the bottom, at the side, chosen in the description refer to the directly described and depicted figure and in case of a change of position, these specifications of location are to be analogously transferred to the new position.

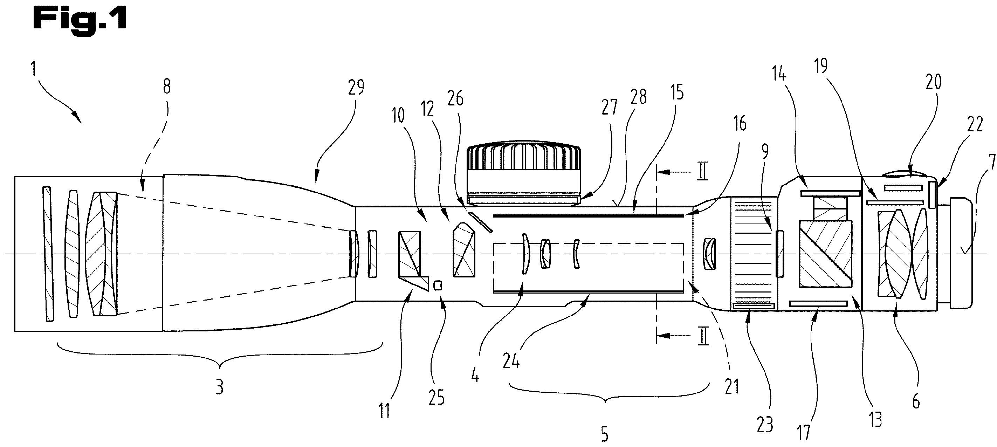

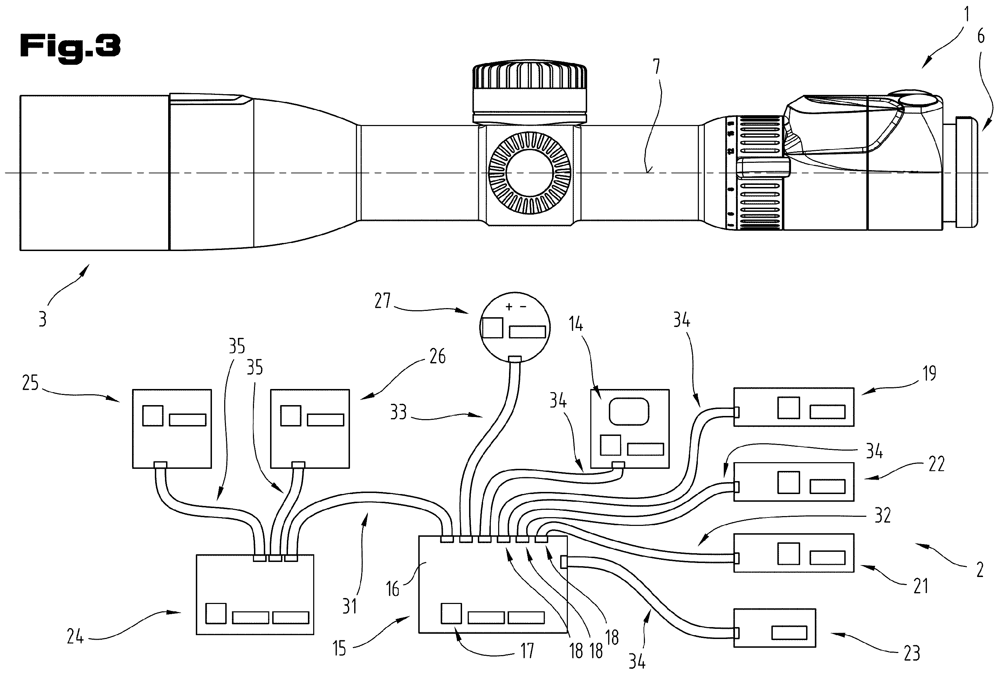

A first exemplary embodiment of an optical imaging device 1 is described with reference to the following Figs. 1 to 3. Fig. 1 shows a side view of the optical imaging device 1 formed by a sighting telescope. This is an optical imaging device that is configured with an electronic control system 2 (Fig. 3) to perform and/or support various of its functions.

To generate and display a magnified image of a distant object, the sighting telescope is configured having an objective lens 3, a lens erecting system 5 and an eyepiece 6. According to this exemplary embodiment, a field lens 4 is also provided, as shown. An optical axis 7 of an observation beam path 8 of the sighting telescope is determined by these optical elements. In addition to a reticle 9, the sighting telescope also has a rangefinder 10 with a transmitter prism system 11 and a receiver prism system 12. Finally, a display prism 13, with the aid of which information generated by the electronic control system 2 can be displayed to a user in the observation beam path 8 together with the image of the distant object, is also arranged between the reticle 9 and the eyepiece 6. The beam path 8 extending in the direction of the optical axis 7 can also be referred to as the primary beam path and/or observation beam path of the optical device 1. The rangefinder 10 is optically coupled to this observation beam path 8 by means of the transmitter prism system 11 and the receiver prism system 12. On the other hand, a display 14 is also coupled into the primary beam path 8 with the aid of the display prism 13.

The electronic control system 2 of the optical device 1 is realized by circuit boards and flexible data connections connecting them to each other. In the optical device 1 according to this exemplary embodiment, at least one main controller 15 is formed. It comprises a first circuit board 16 with a main processor 17 and multiple interface components 18. However, data connections between the circuit boards and/or the carrier boards can also be realized by connectors or soldered connections.

The term "processor" is to be understood here in the broader sense as a programmable arithmetic unit, i.e. an electronic circuit that executes actions in accordance with transferred instructions. "Electronic control", "main processor", CPU or GPU can therefore also refer to components such as an FPGA (Field Programmable Gate Array), a microcontroller, a microprocessor, a digital signal processor (DSP) or an ASIC (Application-Specific Integrated Circuit). A GPU, i.e. an electronic circuit originally designed for digital image processing and to accelerate computer graphics, is also advantageous as a control component because of their ability at handling data-intensive and computationally demanding tasks.

For reasons of clarity, only the circuit board 16 of the main control unit 15 and the aforementioned electronic components are shown in Fig. 1. This simplified representation is also used for the other subunits of the electronic control system 2. Thus, in addition to the display 14, the electronic control system 2 of the optical device 1 according to this exemplary embodiment also has an electrical and/or electronic user interface 19, a button 20 for starting and/or triggering a measurement process with the rangefinder 10 as well as sensors, such as an inertial measurement unit (IMU) 21, an air pressure sensor 22 and a zoom detector 23. To measure and report a body's specific force, angular rate, and sometimes the orientation of the body, accelerometers and gyroscopes are combined in an inertial measurement unit (IMU). Finally, the range finder 10 also comprises range-finding electronics 24, to which a radiation emitter 25 and a radiation detector 26 are connected. An energy source 27, preferably formed by an electric accumulator, is provided for operating the electronic control system 2.

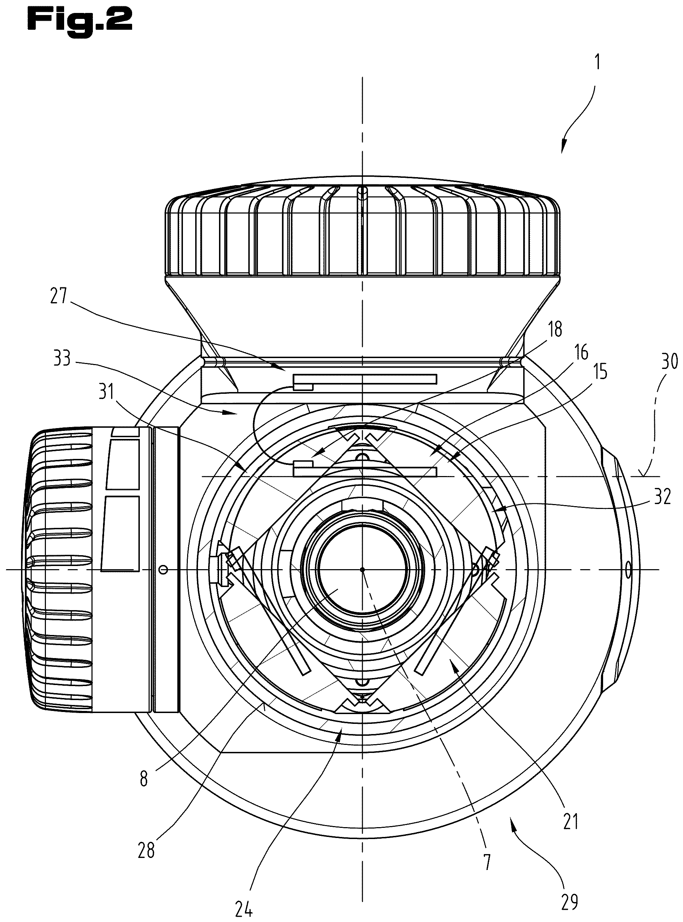

Fig. 2 shows a cross-section through the sighting telescope according to Fig. 1. The circuit board 16 of the main control unit 15 and the circuit boards of the range-finding electronics 24 and the inertial measurement unit 21 are arranged around the beam path 8 with the optical axis 7, meaning that the circuit boards are arranged outside the beam path 8. They are thus located in an area within a central tube 28 of a housing 29 of the optical device 1, between the housing 29 and the beam path 8. In this regard, a plate plane 30 of the circuit board 16 of the main control unit 15 is in a position aligned parallel to the optical axis 7. According to this exemplary embodiment, the plate planes of the circuit boards of the range-finding electronics 24 and the inertial measurement unit 21 are also aligned parallel to the optical axis 7. This is also the case for the circuit board of the battery and/or the energy source 27. The plate plane 30 of the circuit board 16 of the main controller 15 is angled and/or inclined relative to the respective plate planes of the circuit boards of the range-finding electronics 24 and the inertial measurement unit 21.

A flexible data connection 31 leads from one of the interface components 18 on the circuit board 16 of the main control unit 15 to the range-finding electronics 24. The flexible data connection 31 is configured in the form of a cable harness and is preferably formed by a ribbon cable.

In the same way, in each case, a second flexible data connection 32 leads from further interface components 18 of the main control unit 15 to the inertial measurement unit 21 and a third flexible data connection 33 leads to the battery or the energy source 27.

Figs. 3 shows the optical imaging device 1 with its electronic control system 2 as a block diagram. The circuit boards of the range-finding electronics 24, the inertial measurement unit 21 and the energy source 27 are connected to the circuit board 16 of the main control unit 15 by means of the flexible data connections 31, 32, 33. The cable harnesses of the flexible data connections 31, 32, 33 are each connected to one of the interface components 18 by a detachable plug connection. This is also the case in the same way for flexible data connections 34 between the main control unit 15 and the display 14, the user interface 19, the button 20, the air pressure sensor 22 and the zoom detector 23. In addition, the radiation emitter 25 and the radiation receiver 26 can also each be connected to the range-finding electronics 24 by means of a flexible data connection 35.

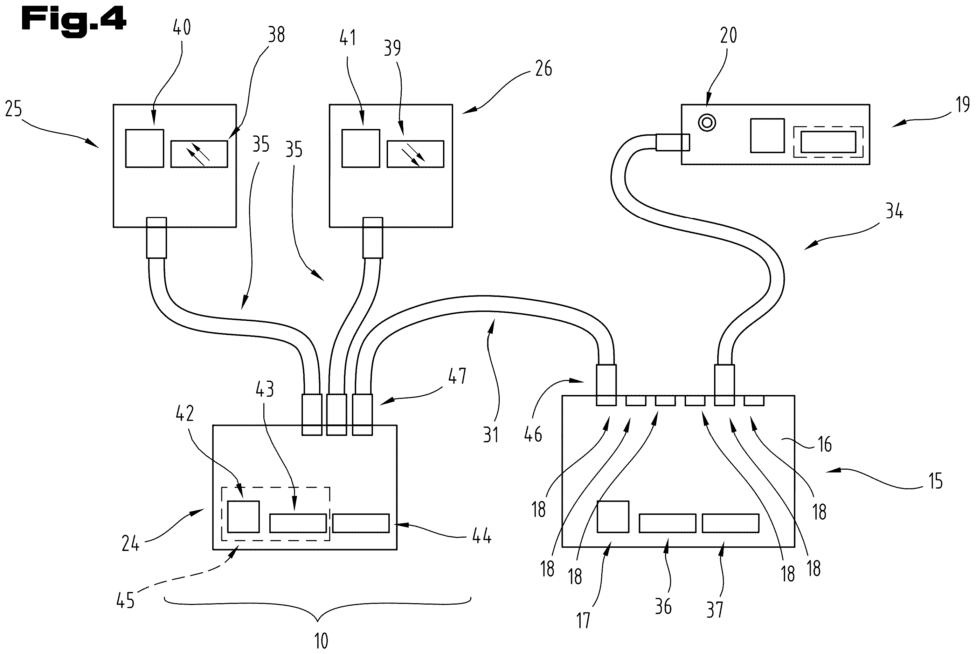

Fig. 4 shows a section of the block diagram according to Fig. 3 with the main control unit 15, the range-finding electronics 24 and the input terminal 19. The circuit board 16 of the main control unit 15 carries at least a first memory 36 in addition to the main processor 17. The control program for the operation of the optical device 1 is permanently stored in this first memory 36. In a second memory 37 of the main control unit 15 and/or the circuit board 16, data of the operating states occurring during the operation of the device 1 are buffered.

The circuit board of the input terminal 19 carries at least the button 20. A user can start a measurement process with the rangefinder 10 using the button 20 when using the sighting telescope 1. Preferably, the user terminal 19 has multiple buttons 20. In an alternative embodiment, however, a touchscreen can also be provided on the input terminal 19.

For distance measurement, the circuit board of the radiation emitter 25 has a laser diode 38 for emitting light pulses directed at a distant object. Correspondingly, the circuit board of the radiation receiver 26 has a photodiode 39, preferably an APD (avalanche photodiode), for detecting reflected light pulses. To provide the required electrical energy, a power supply 40 is provided on the circuit board of the radiation emitter 25 and, on the other hand, a power supply 41 is provided on the circuit board of the radiation receiver 26. In particular, it is provided that the power supply 40 of the radiation emitter 25 is configured to have a control. It is configured to keep the energy of the laser pulses of the laser diode 38 constant and/or to reduce fluctuations as far as possible. It can also be provided that the power supply 41 of the radiation receiver 26 is configured to have a control by means of which the high voltage required to supply the avalanche photodiode is kept constant. These measures improve the measuring performance of the rangefinder 10.

The energy supplies 40, 41 of the rangefinder 10 in turn receive the required electrical energy from the energy source 27, wherein the current can be conducted via the cable harnesses of the data connections 33, 31, 35.

The start of the measurement of a distance is triggered by pressing the button 20 of the input terminal 19. However, the control of the sequence of a measurement cycle with the help of the radiation emitter 25 and the radiation receiver 26 as well as the subsequent calculation of the value of the distance from the measured transit time values of the light pulses is carried out independently by the range-finding electronics 24. For this purpose, a separate CPU 42, a memory 43 for recording the control program and a memory 44 for the intermediate storage of data arising during the measurement are provided on the circuit board of the range-finding electronics 24. According to this exemplary embodiment, the CPU 42 and the memory 43 for the program code are arranged together on the circuit board of a measuring module 45. This measuring module 45 with the CPU 42 and with the memory 43 is attached to the circuit board of the range-finding electronics 24 by means of a detachable plug-in connection. The measuring module 45 can therefore be plugged onto the circuit board of the range-finding electronics 24 and can thus be replaced. The structuring of the range-finding electronics 24 into a circuit board carrying the measuring module 45 on the one hand and the measuring module 45 with the CPU 42 and with the memory 43 on the other hand offers the advantage of being able to manufacture rangefinders 10 with specifically adapted functionalities.

The transmission of a distance value calculated by the evaluation using the range-finding electronics 24 for its display on the electronic display 14 takes place under the control of the main control unit 15 by retrieving and transmitting it via the data connection 31. The main control unit 15 then transmits the datum of the distance value to the circuit board of the display 14 via the further data connection 34. The flexible data connection 31 between the main control unit 15 and the range-finding electronics 24 and/or between the corresponding circuit boards comprises a cable harness with a first end portion 46 and a second end portion 47. The first end portion 46 and the second end portion 47 are preferably configured in the form of a plug, with the first end portion 46 being connected to one of the interface components 18 of the main control unit 15 and the second end portion 47 being connected to one of the corresponding interface components of the circuit board of the range-finding electronics 24. In the connected state, a plug-in direction of the first end portion 46 is directed parallel to the plane 30 of the circuit board 16 of the main control unit 15. Preferably, this is also the case for the second end portion 47 on the circuit board of the range-finding electronics 24.

In a preferred embodiment, the connection of the flexible data connection 31 to the circuit board 16 of the main control unit 15 is in the form of a plug-and-play bus system.

In particular, in the data connection 35 between the circuit board of the range-finding electronics 24 and the circuit board of the radiation receiver 26 with the sensor and/or the photodiode 39, it is provided that the connections of the end portions of the data connection 35 are formed with a unique physical shape. Mixing up the connections and thus faulty connections between the components of the electronic modules can thus be prevented. Such a unique assignment of the physical shape of the corresponding plug/socket pairings is also provided in the case of the other sensors, such as the inertial measurement unit 21, the air pressure sensor 22 or the zoom detector 23.

The configuration of the flexible data connection 31 to 35 by means of ribbon cables and their connection to the corresponding circuit boards with a plug-in direction parallel to the planes 30 of the circuit boards favors a space-saving arrangement of the electrical and/or electronic components in the housing 29 or in spaces between an inner side of the housing 29 and the beam path 8 of the optical imaging device 1. On the other hand, this also makes it possible that, in a state not yet installed in the optical device 1, the circuit boards 16 of the control system 2 connected to one another by the data connections 31 to 35 can be laid out and/or arranged in a common single plane.

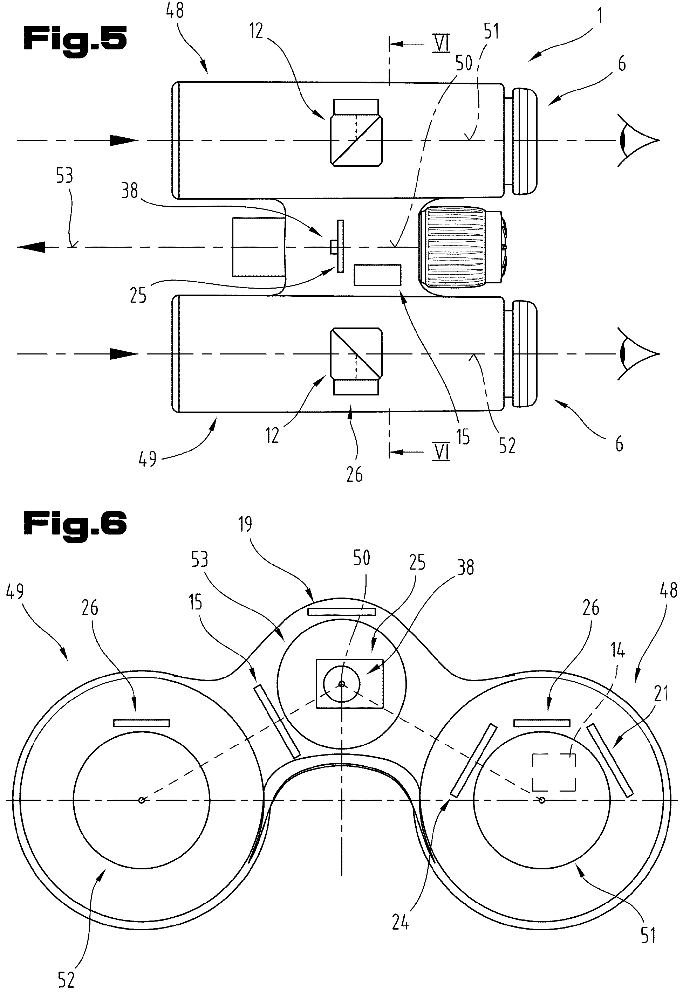

Figs. 5, 6 show a further and possibly independent embodiment of the optical imaging device 1, wherein again, equal reference numbers and/or component designations are used for equal parts as in Figs. 1 to 4 above. In order to avoid unnecessary repetitions, it is pointed to/reference is made to the detailed description in Figs. 1 to 4 above.

A first exemplary embodiment of an optical imaging device 1 is described with reference to Figs. 5 and 6.

Fig. 5 shows a binocular, as a further exemplary embodiment of an optical imaging device 1, in a top view. With a first tube 48 and a second tube 49, it comprises two housing parts that can be pivoted about a hinge axis 50. The radiation emitter 25 of a rangefinder of the binocular is formed in a hinged bridge connecting the two tubes 48, 49. By the optically imaging components in the two tubes 48, 49 and by the radiation emitter 25, thus, two observation beam paths 51, 52 and a measuring beam path 53 aligned parallel thereto are realized. Light reflected by an object from the laser pulses of the radiation emitter 25 is coupled out by the receiver prism systems 12 in the two observation beam paths 51, 52 and detected by a radiation receiver 26 in each case.

Fig. 6 shows a cross-section of the binocular according to Fig. 5. The figure shows the respective observation beam paths 51, 52 schematically indicated in the two tubes 48, 49. The control of a measurement of the distance of a distant object is carried out under the control of the range-finding electronics 24, wherein light pulses are emitted from the laser diode 38 of the radiation emitter 25 through the measuring beam path 53. Measurement signals detected by the radiation receivers 26 are then transmitted to the range-finding electronics 24 and evaluated by it. The value of the measured distance can then be retrieved by the main control unit 15 and displayed on the display 14 in the observation beam path 51 of the right tube 48. For reasons of clarity, the data connections 31 to 35 between the circuit boards 16 of the main control unit 15, the input terminal 19, the range-finding electronics 24, the radiation emitter 25, the radiation receiver 26 and the inertial measurement unit 21 are not shown. Their configuration and mode of operation correspond to those already described with reference to Figs. 3 and 4.

The circuit boards 16 of the main control unit 15, the range-finding electronics 24 of the radiation emitter 25, the radiation receiver 26 and the inertial measurement unit 21 are arranged in intermediate spaces between the interior of the housing of the two tubes 48, 49 and the observation beam paths 51, 52 and/or the measuring beam path 53. The planes of the circuit boards are each aligned parallel to the optical axes of the nearest sections of the corresponding beam paths 51, 52, 53. The circuit board of the radiation emitter 25 is aligned essentially perpendicular to the optical axis of the measuring beam path 53 (Fig. 5).

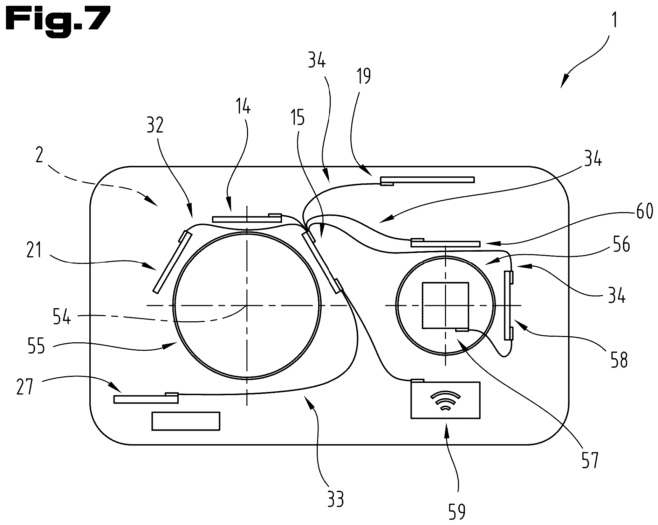

Fig. 7 shows a further exemplary embodiment of an optical imaging device 1, represented by a cross-section with respect to an optical axis 54 of an observation beam path 55. This device is a monocular observation device with a camera function. In addition to the observation beam path 55 for directly viewing a magnified image of the distant object, the observation device has an image capturing beam path 56 aligned parallel to the optical axis 54 of the observation beam path 55. Therein, an electronic camera 57 for recording digital images of the object being viewed is provided. The camera 57 is preferably a CCD array positioned in an image plane of the optical elements of the image capturing beam path 56.

A user of the observation device can initiate the capturing of images with the camera 57 during observation by actuating the input terminal 19. The execution of commands entered at the input terminal 19 is again under the control of the main control unit 15. The circuit board 16 of the main control unit 15 is connected to the energy source 27, the display 14, the input terminal 19 and the inertial measurement unit 21 via one of the flexible data connections 31 to 34. Digital images captured by the camera 57 are transmitted to an image processing module 58 and only then to the main control unit 15. In addition, it may also be provided that the images are transmitted from the main control unit 15 to the display 14 for common display in the field of view of the observation beam path 55.

In a preferred embodiment of the observation device, it may also be provided that the observation device comprises a WIFI module 59 so that images and image information data are transmitted from the main control unit 15 to external terminals after corresponding input at the input terminal 19. The observation device 1 can also include, for example, a receiver module 60 of a global positioning system (such as GPS). Images captured by the camera 57 can therefore also be linked to geographical position information and/or their image information data can be expanded accordingly.

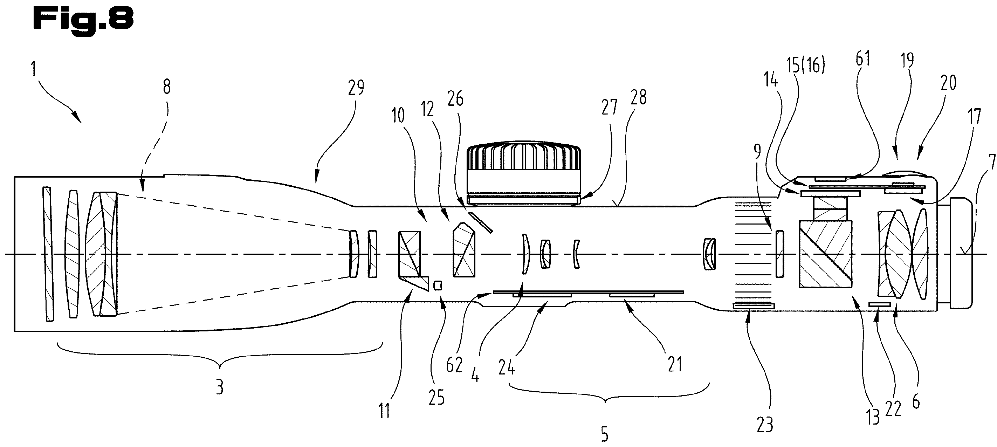

A preferred embodiment of the optical device 1 in the form of a sighting telescope is described with reference to Figs. 8 to 14. Fig. 8 shows a schematic diagram of the optical device 1, with the optical elements of the beam path 8 on the one hand and the electronic components of the electronic control system 2 on the other hand.

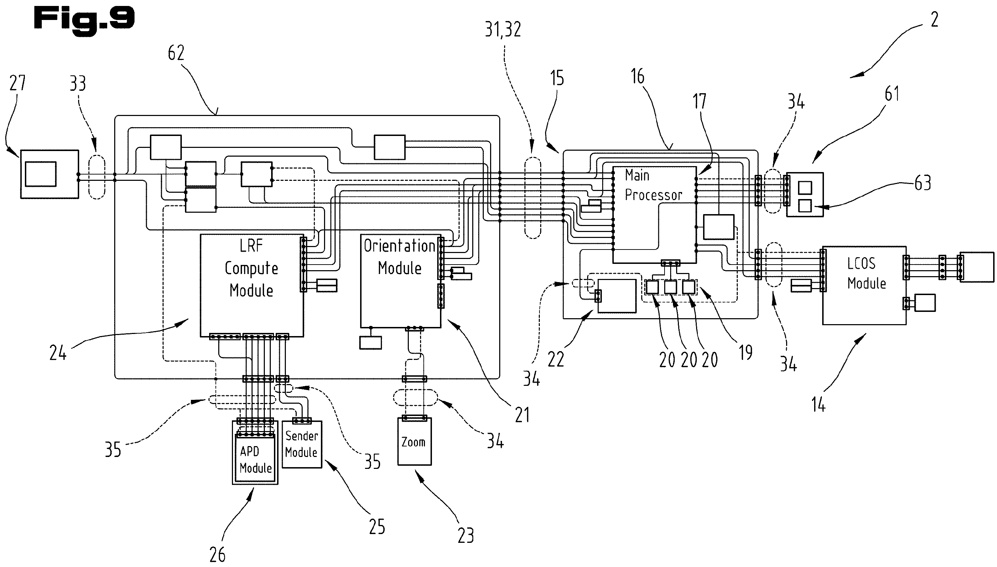

In addition to the possibility of visually observing a distant object through the eyepiece 6 of the sighting telescope 1, it also has the rangefinder 10. In this regard, the beam paths of the rangefinder 10, which is configured as a laser rangefinder, are guided via the beam path 8 in that light emitted by the radiation emitter 25 is coupled into the beam path 8 via the transmitter prism system 11 and- on the other hand - light reflected by a distant object is decoupled from the same visual beam path 8 with the aid of the receiver prism system 12 and absorbed by the radiation detector 26. Finally, a result of the distance measurement calculated by the range-finding electronics 24 can be displayed on the display 14 and shown to an observer using the display prism 13 in the subjective field of view of the eyepiece 6. The display 14 is preferably formed by a so-called LCoS display. In addition to the result of the distance measurement, which is shown on the display 14 in the form of a numerical value, other information can also be displayed. This includes variables that are detected by corresponding sensors. For example, the zoom detector 23 can be used to determine the set magnification of the sighting telescope. In addition to an air pressure sensor 22, a thermometer can also be provided. The inertial measurement unit 21 has acceleration sensors, angular rate sensors and a magnetometer. The electrical energy required to supply the electronic control system 2 is provided by a battery of the energy source 27. A status LED 61 makes it possible to display the respective operating status of the sighting telescope 1. For manual operation of the control system 2 by a user, three buttons 20 of the input terminal 19 are preferably available to the user (Fig. 9).

The circuit board 16 of the main control unit 15 carries both the main processor 17 and at least one of the buttons 20 of the input terminal 19. The circuit board 16 of the main control unit 15 thus also serves as a motherboard for different main processors 17, depending on the model of the sighting telescope. In an analogous manner, a common motherboard 62 is provided which serves as a carrier for the circuit boards of the range-finding electronics 24 and the inertial measurement unit 21. The various electronic components are interconnected by ribbon cables to supply them with electrical power and to transfer data between them. For reasons of clarity, however, these are not shown in Fig. 8.

Fig. 9 shows the corresponding electrical circuit diagram of the control system 2 of the sighting telescope according to Fig. 8. Organizationally, the main processor 17 on the circuit board 16 of the main control unit 15 is at the center of the electronic control system 2 in this regard. The circuit board 16 is connected on the one hand to the motherboard 62 with the range-finding electronics 24 and the inertial measurement unit 21 (data connections 31, 32) and on the other hand to the circuit board of the display 14 (data connection 34). As a further display component, the status LED 61 is also connected to the circuit board 16 of the main control unit 15 by a further flexible data connection 34. A brightness sensor 63 for measuring the ambient brightness may also be arranged on the circuit board of the status LED 61.

On the other hand, data connections 35 are provided on the motherboard 62 for connecting the range-finding electronics 24 to the radiation emitter 25 as well as to the radiation detector 26. Similarly, the zoom detector 23 is also connected to the inertial measurement unit 21 - with interposition of the motherboard 62. The supply voltage of the energy source 27 is initially fed to the motherboard 62 and looped through from it to all other electrical components.

With the help of the three buttons 20 (T1, T2, T3) of the operator terminal 19, a user can cause different operating states of the electronic control system. These include starting up the main control unit 15 or booting the main processor 17, starting a measurement process for distance measurement using the radiation emitter 25 and the radiation detector 26 as well as selecting different variables for display on the display 14. For this purpose, a menu control can be provided in the main processor 17, wherein the user is shown corresponding options for selection on the display 14 and can start the execution of the corresponding function by pressing one of the buttons 20 (T1, T2, T3).

A bus system is formed via the data connections 31, 32, 33, 34 for exchanging data between the various electronic components of the control system 2. According to the invention, the data connections 31 to 34 comprise a so-called one-wire bus. The special features of the one-wire bus used are explained in more detail below.

The control of the radiation emitter 25 as well as the acquisition of measurement signals from the radiation detector 26 by the range-finding electronics 24 takes place via the data connections 35, wherein the signals are transmitted in analog form. The laser of the radiation emitter 25 is controlled by the range-finding electronics 24 in a defined measurement cycle to emit a series of laser pulses. Radiation reflected from a distant object is received by an avalanche photodiode of the radiation detector 26 and a resulting measurement signal can be measured by the range-finding electronics 24.

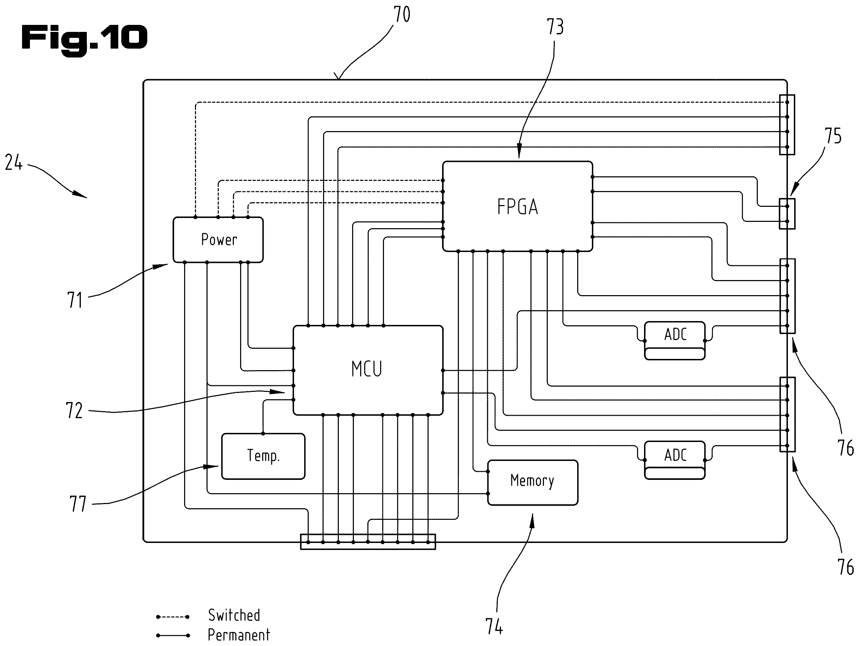

Fig. 10 shows details of the range-finding electronics 24 according to Fig. 9

In this range-finding electronics 24, a microcontroller 72, a measurement controller 73 and a memory 74 are arranged on a separate circuit board 70 in addition to a local energy supply 71. The measurement controller 73 comprises an FPGA module (Field Programmable Gate Area). It is connected to the radiation emitter 25 and/or the radiation detector 26 via a transmitter interface 75 and a receiver interface 76. A second receiver interface 76 can also be formed on the range-finding electronics 24. The range-finding electronics 24 shown can thus also be used in rangefinders 10 in which two radiation detectors 26 are provided. The module of the range-finding electronics 24 can also be configured to have a temperature sensor 77.

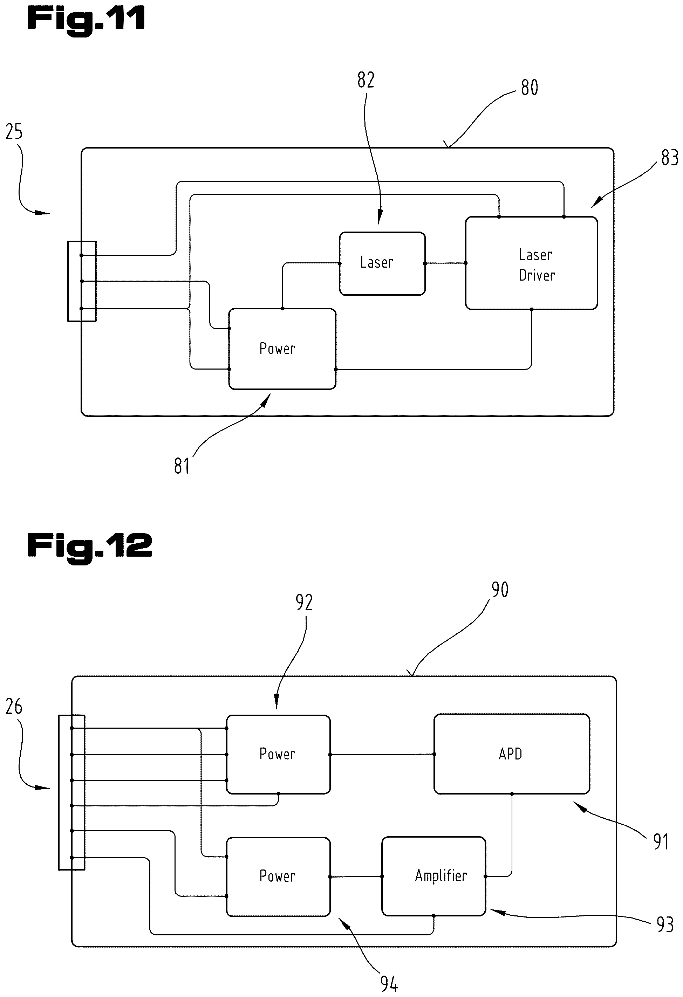

Fig. 11 shows the radiation emitter 25 according to Fig. 9 in the form of a transmitter module with its components arranged on a circuit board 80. These include a local energy supply 81, a laser 82 and a laser driver 83.

Fig. 12 shows the radiation detector 26 according to Fig. 9. The radiation detector 26 also has a modular configuration with its own circuit board 90. The radiation detector 26 has an avalanche diode 91 (APD) as a sensor for detecting reflected laser light. A first energy supply 92 is provided to generate the high voltage required to operate the avalanche diode 91. The measuring current of the avalanche diode 91 can be additionally amplified with the aid of a signal amplifier 93. A separate energy supply 94 is provided for this purpose.

According to this exemplary embodiment of the electronic control system 2 of the sighting telescope, the individual modules, i.e. the module of the range-finding electronics 24, the module of the radiation emitter 25 and the module of the radiation detector 26 are arranged on the motherboard 62 and/or electrically connected to it. In the case of the module of the range-finding electronics 24, the motherboard 62 includes a socket for plugging the module of the range-finding electronics 24 directly onto the motherboard 62. In contrast, the module of the radiation emitter 25 as well as the module of the radiation detector 26 are electrically connected to the motherboard 62 by means of the data connections 35 formed by ribbon cables.

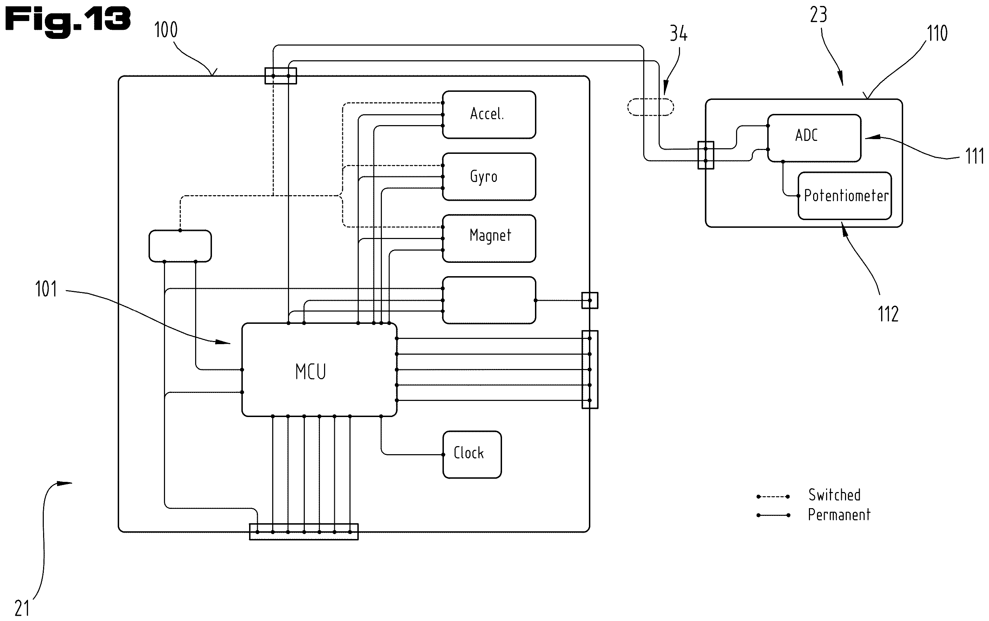

Fig. 13 shows the module of the inertial measurement unit 21 (IMU) and the module of the zoom detector 23 connected to it as a detail of Fig. 9. Analogous to the situation of the module of the range-finding electronics 24, the module of the inertial measurement unit 21 is also plugged into a corresponding slot on the motherboard 62 and/or connected to it (Fig. 9). A circuit board 100 acts as a carrier for the electronic components attached to it in this regard. A microcontroller 101 is provided for controlling the individual measurements and evaluating the measurement signals from multiple sensors. These include at least one acceleration sensor 102, a gyroscope 103 and a magnetometer 104, which are also arranged on the common circuit board 100. According to this exemplary embodiment, the microcontroller 101 of the inertial measurement unit 21 is also connected to the zoom detector 23 for detecting the instantaneous magnification of the sighting telescope.

The zoom detector 23 is configured as an independent module with a separate circuit board 110, an analog-to-digital converter 111 arranged thereon and a potentiometer 112. The zoom detector 23 is connected to the microcontroller 101 of the inertial measurement unit 21 by a ribbon cable of the data connection 34.

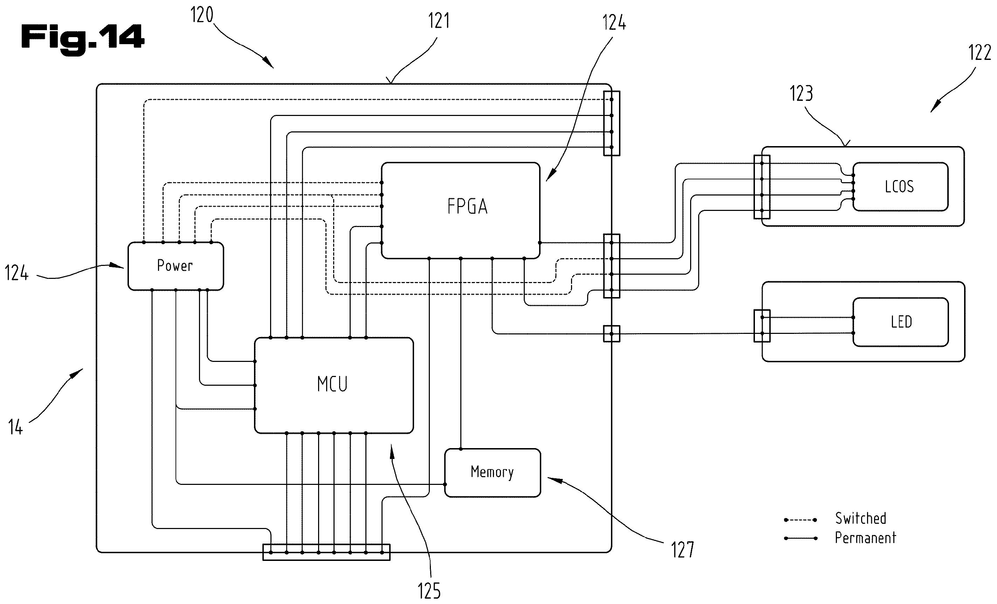

Fig. 14 shows the module of the display 14 according to Fig. 9. This comprises at least two submodules of a display control 120 on a first circuit board 121 and an LCoS display 122 on a second circuit board 123. In addition to a local energy supply 124, a microcontroller 125, an FPGA module 126 and a memory 127 are arranged on the circuit board 121 of the display controller 120.

A special aspect of the optical device 1 and/or the electronic control system 2 is the bus designed for data exchange between the individual modules of the electronic control system 2. For data exchange between the modules, in particular of the inertial measurement unit 21, the range-finding electronics 24 and the display 14, with the main processor 17, a so-called one-wire bus is formed using a UART circuit (Universal Asynchronous Receiver Transmitter), which serve to realize digital serial interfaces. It is possible for a participant in the bus to decide whether it also receives the data it has sent itself in order to check whether the data has been transmitted correctly.

Another important aspect of the optical device 1 is represented by the modular design of individual components of the electronic control system 2. This allows for extended application possibilities in the construction of new models of optical devices 1. In this way, a group of universally applicable components with electrical interfaces and correspondingly different functions can be provided. Such components are, for example, the modules of the main control unit 15, the display 14, the inertial measurement unit 21 or the range-finding electronics 24, but also the radiation emitter 25 and the radiation detector 26. Thus, depending on the type of optical device 1, those components specific to the desired function of the optical device 1 can be selected and interconnected to form a desired electronic control system and can also be arranged on a carrier board, such as the motherboard 62 in Fig. 9. Thus, when designing the electronic control system 2 for the optical device 1 to be constructed, it is only necessary to take into account the design-specific space conditions within the housing of the optical device 1 when designing the carrier boards. In this respect, a high degree of flexibility can be achieved in the design of the electronic control system 2 in that only the external shape of the carrier boards and the positions of the interfaces or slots on the carrier boards need to be selected and adapted.

A method and/or process for manufacturing an electronic control system 2 for an optical device 1 with at least one objective lens and an electro-optical receiver can thus be defined with the following process steps.
a) Provision of individual, universal electronic assemblies with interfaces and different functions, such as computers, sensors, display controller, camera controller, laser emitters, receivers;
b) Selection of assemblies taking into account the desired function of the optical device 1;
c) Production of one or more carrier boards and grouping and arrangement of the electronic assemblies, taking into account the space available in the optical device 1;
d) If necessary, supplementing the carrier boards with additional electronic functions and/or assemblies;
e) Adding specific assemblies such as operating elements, battery connection, electro-optical displays or sensors as required;
f) Connecting the assemblies and/or the carrier boards via the electrical interfaces using cables or flexible circuit boards.

The exemplary embodiments show possible embodiment variants, and it should be noted in this respect that the invention is not restricted to these particular illustrated embodiment variants of it, but that rather also various combinations of the individual embodiment variants are possible and that this possibility of variation owing to the technical teaching provided by the present invention lies within the ability of the person skilled in the art in this technical field.

The scope of protection is determined by the claims. Nevertheless, the description and drawings are to be used for construing the claims. Individual features or feature combinations from the different exemplary embodiments shown and described may represent independent inventive solutions. The object underlying the independent inventive solutions may be gathered from the description.

All indications regarding ranges of values in the present description are to be understood such that these also comprise random and all partial ranges from it, for example, the indication 1 to 10 is to be understood such that it comprises all partial ranges based on the lower limit 1 and the upper limit 10, i.e. all partial ranges start with a lower limit of 1 or larger and end with an upper limit of 10 or less, for example 1 through 1.7, or 3.2 through 8.1, or 5.5 through 10.

Finally, as a matter of form, it should be noted that for ease of understanding of the structure, elements are partially not depicted to scale and/or are enlarged and/or are reduced in size.

**List of reference numbers**

| | | | |
|---|---|---|---|
| 1 | Optical device | 32 | Data connection |
| 2 | Electronic control system | 33 | Data connection |
| 3 | Objective lens | 34 | Data connection |
| 4 | Field lens | 35 | Data connection |
| 5 | Lens erecting system | 36 | Memory |
| 6 | Eyepiece | 37 | Memory |
| 7 | Optical axis | 38 | Laser diode |
| 8 | Beam path (optical path) | 39 | Photodiode (avalanche photodiode) |
| 9 | Reticle | | |
| 10 | Rangefinder | 40 | Energy supply |
| 11 | Transmitter prism system | 41 | Energy supply |
| 12 | Receiver prism system | 42 | CPU |
| 13 | Display prism | 43 | Memory |
| 14 | Display | 44 | Memory |
| 15 | Main control unit | 45 | Measuring module |
| 16 | Circuit board | 46 | End portion |
| 17 | Main processor | 47 | End portion |
| 18 | Interface component | 48 | Tube |
| 19 | Input terminal | 49 | Tube |
| 20 | Button | 50 | Hinge axis |
| 21 | Inertial Measurement Unit (IMU) | 51 | Observation beam path |
| 22 | Air pressure sensor | 52 | Observation beam path |
| 23 | Zoom detector | 53 | Measuring beam path |
| 24 | Range-finding electronics | 54 | optical axis |
| 25 | Radiation emitter | 55 | Observation beam path |
| 26 | Radiation detector | 56 | Image capturing beam path |
| 27 | Energy source | 57 | Camera |
| 28 | Central tube | 58 | Image processing module |
| 29 | Housing | 59 | WIFI module |
| 30 | Plate plane | 60 | Receiver module (GPS) |
| 31 | Data connection | 61 | Status LED |
| 62 | Motherboard (base board) | 95 | |
| 63 | Brightness sensor | 96 | |
| 64 | | 97 | |
| 65 | | 98 | |
| 66 | | 99 | |
| 67 | | 100 | Circuit board |
| 68 | | 101 | Microcontroller |
| 69 | | 102 | Acceleration sensor |
| 70 | Circuit board | 103 | Gyroscope |
| 71 | Energy supply | 104 | Magnetometer |
| 72 | Microcontroller | 105 | |
| 73 | Measurement controller | 106 | |
| 74 | Memory | 107 | |
| 75 | Transmitter interface | 108 | |
| 76 | Receiver interface | 109 | |
| 77 | Temperature sensor | 110 | Circuit board |
| 78 | | 111 | Analog-to-digital converter |
| 79 | | 112 | Potentiometer |
| 80 | Circuit board | 113 | |
| 81 | Energy supply | 114 | |
| 82 | Laser | 115 | |
| 83 | Laser driver | 116 | |
| 84 | | 117 | |
| 85 | | 118 | |
| 86 | | 119 | |
| 87 | | 120 | Display controller |
| 88 | | 121 | Circuit board |
| 89 | | 122 | LCoS display |
| 90 | Circuit board | 123 | Circuit board |
| 91 | Avalanche diode | 124 | Energy supply |
| 92 | Energy supply | 125 | Microcontroller |
| 93 | Signal amplifier | 126 | FPGA module |
| 94 | Energy supply | 127 | Memory |

## Claims

1. An apparatus comprising an optical device (1) having an objective lens system (3) with a primary optical path (8) and an electronic control system (2), wherein the electronic control system (2) comprises:
- a main circuit board (16) with a main processor (17) and at least an electronic interface (18) for communication with a data bus,
- and at least two subordinate circuit boards (21, 24),
- **characterized in that** each of the two subordinate circuit boards (21, 24) comprises a controller and at least an electronic interface (18) for communication with the data bus,
- wherein the main circuit board (16) and each of the two subordinate circuit boards (21, 24) are connected to the data bus,
- and wherein the subordinate circuit boards (21, 24) are in communication with the main circuit board (16) over the data bus,
- and wherein at least one of the subordinate circuit boards (21, 24) comprises a measuring device (22, 23, 25, 26).

2. The apparatus according to claim 1, **characterized in that** the controller of each of the subordinate circuit boards (21, 24) is designed such that a measurement is executed independently from the main processor (17).

3. The apparatus according to claim 1, **characterized in that** the main circuit board (16) and the subordinate circuit boards (21, 24) are arranged outside the primary optical path (8) with the main circuit board (16) lying in a first plane (30) and the subordinate circuit boards (21, 24) lying in a second plane that is inclined relative to the first plane (30).

4. The apparatus according to claim 1, **characterized in that** the first plane (30) and/or the second plane is aligned parallel to an adjacent portion of the primary optical path (8).

5. The apparatus according to claim 1, **characterized in that** only one of the first plane (30) and the second plane is aligned perpendicular to an adjacent portion of the primary optical path (8).

6. The apparatus according to any one of claims 1 to 3, **characterized in that** the measuring device is selected from a group consisting of an IMU module (21) (Inertial Measurement Unit), a compass, a thermometer, a rangefinder (10), a microphone, a module for wind speed measurement and a module for cross wind measurement.

7. The apparatus according to any one of the preceding claims, **characterized in that** the subordinate circuit board (21, 24) comprises a device for communication, wherein the device for communication is selected from a group consisting of a Bluetooth module, a WIFI (59) module, a loudspeaker and a graphics module for outputting image information data to a display (14) arranged in the primary optical path (8).

8. The apparatus according to one of the preceding claims, **characterized in that** the subordinate circuit board (21, 24) includes a second controller (42) or a GPU.

9. The apparatus according to claim 8, **characterized in that** the second controller (42) comprises a CPU or a GPU.

10. The apparatus according to one of the preceding claims, **characterized in that** the subordinate circuit board (21, 24) comprises a memory.

11. The apparatus according to claim 7, **characterized in that** the subordinate circuit board (21, 24) comprises a volatile memory.

12. The apparatus according to claim 7, **characterized in that** the subordinate circuit board (21, 24) comprises a non-volatile memory (43, 44).

13. The apparatus according to one of the preceding claims, **characterized in that** the data bus comprises a flexible data connection (31 to 35) and that at least one of the flexible data connections (31 to 35) is equipped with a connector having a unique physical configuration to receive a specific connector of only one sensor of the group of sensors or of only one of the devices of the group of devices for communication.

14. The apparatus according to one of the preceding claims, **characterized in that** a connection of a first flexible data connection (31) to the main circuit board (16) is via a first connector (18) on the main circuit board (16) that comprises a plug-and-play bus.

15. The apparatus according to claim 12, **characterized in that** the subordinate circuit board (21, 24) includes a second connector and the flexible data connection (31, 32) comprises a cable assembly connecting the main circuit board (16) to the subordinate circuit board (21, 24), wherein the cable assembly has a first end portion (46) connected to the first connector (18) and has a second end portion (47) connected to the second connector.

16. The apparatus according to claim 15, **characterized in that** a first tangent applied to the first end portion (46) of the cable assembly and a second tangent applied to the second end portion (47) of the cable assembly enclose an angle which angle is equal to an angle of inclination between the first plane (30) of the main circuit board (16) and the second plane of the subordinate circuit board (21, 24).

17. The apparatus according to claim 15, **characterized in that**, in an assembled state, the main circuit board (16), the subordinate circuit boards (21, 24), and the cable assembly connecting the main circuit board (16) and the subordinate circuit boards (21, 24) can be laid out together in essentially a single common plane prior to installation in the optical device (1).

18. The apparatus according to one of the preceding claims, **characterized in that** an another subordinate circuit board (21, 24) is comprised, wherein a third plane of the another subordinate circuit board (21, 24) is aligned relative to the second plane of the subordinate circuit board (21, 24) so that the third plane is inclined relative to the second plane.

19. The apparatus according to one of the preceding claims, **characterized in that** a battery is comprised.

20. An apparatus for the electronic or electromechanical control of an optical device (1), the apparatus comprising:
- a main circuit board (16) with a main processor (17) and at least an electronic interface (18) for communication with a data bus,
- and at least two subordinate circuit boards (21, 24),
- **characterized in that** each of the two subordinate circuit boards (21, 24) comprises a controller and at least an electronic interface (18) for communication with the data bus,
- wherein the main circuit board (16) and each of the two subordinate circuit boards (21, 24) are connected to the data bus,
- and wherein the subordinate circuit boards (21, 24) are in communication with the main circuit board (16) over the data bus,
- and wherein at least one of the subordinate circuit boards (21, 24) comprises a measuring device (22, 23, 25, 26).

21. The apparatus according to claim 20, **characterized in that** a first connector of the main circuit board (16) and a second connector of the subordinate circuit boards (21, 24) are connected to one another, wherein the first flexible data connection (31) comprises a cable assembly which has a first end portion (46) and a second end portion (47).
